# EUROPÄISCHE PATENTANMELDUNG

(11) **EP 2 677 850 A2**
(43) Veröffentlichungstag der Anmeldung: **25.12.2013**
(21) Anmeldenummer: 13002669.3
(22) Anmeldetag: 22.05.2013
(51) Int. Cl.: H05K 13/04

(54) **Vorrichtung zum Bestücken von Substraten mit elektrischen Bauelementen**

(30) Priorität: 01.06.2012 DE 102012010928
(71) Anmelder: Mimot GmbH, 79541 Lörrach (DE)
(72) Erfinder: Mehdianpour, Mohammad, 81829 München (DE); Philipp, Jürgen, 79639 Grenzach- Whylen (DE)
(74) Vertreter: Müller - Hoffmann & Partner

(57) **Zusammenfassung**

Eine Vorrichtung zum Bestücken von zumindest einem Substrat (8) mit elektrischen Bauelementen, die in einem Abholbereich der Vorrichtung bereitstellbar sind, weist einen Bestückkopf (1) zum Aufnehmen und Handhaben der Bauelemente sowie einen linear in einer Längsrichtung (x) verschiebbaren und positionierbaren Tisch (9) auf, auf dem das flache Substrat (8) in einer Arbeitsebene fixierbar ist. Der Bestückkopf (1) ist in einer zur Arbeitsebene parallelen kreisrunden Führungsbahn eines stationären Trägers (3) zwischen dem Abholbereich und dem Tisch (9) verschiebbar und positionierbar. Abholstellen (12) der Bauelemente sind im Abholbereich entlang einer zur Führungsbahn parallelen Abholstrecke angeordnet. Der Bestückkopf (1) ist mittels eines Linearmotors angetrieben ist, dessen permanentmagnetische Statorelemente (15) am Träger (3, 3a, 3b) verankert und dessen Spulenteil fest mit dem Bestückkopf (1) gekoppelt ist, wobei die flachen Statorelemente (15) parallel zur Führungsbahn verlaufend aneinander gereiht sind.

Der Träger (3, 3a, 3b) weist eine zum Substrat (8) parallele ebene Oberfläche auf, auf der die Statorelemente (15) in zirkulärer Reihung flach liegend angeordnet sind. Dadurch vereinfacht sich der Aufbau der Vorrichtung, und die Funktionsteile des Linearmotors können in einer definierten Lagebeziehung gehalten und geführt werden.

## Beschreibung

Die Erfindung bezieht sich nach dem Oberbegriff von Anspruch 1 auf eine Vorrichtung zum Bestücken von zumindest einem Substrat mit elektrischen Bauelementen.

Durch die DE10060205 A ist eine Bestückvorrichtung bekannt geworden, bei der die Bestückköpfe in einer waagerecht verlaufenden Führungsbahn geführt sind, die an einer senkrechten Außenseite eines stationären Trägers ausgebildet ist. Eine Umlenkeinrichtung ermöglicht es, die Bestückköpfe in einer Richtung umlaufend zu bewegen. Der Träger und der Bestückkopf bilden einen Linearmotor, bei dem das Spulenteil am Bestückkopf und die stationären Magnetteile entlang der Führungsbahn angeordnet sind. Die Führungsbahn ist an der Mantelseite des ringförmigen kreisrunden Trägers ausgebildet und bildet eine zur Auflageebene parallele Führungsebene. Die Abholstellen der Bauelemente verlaufen in einer zur Führungsbahn parallelen Abholstrecke. Sie sind an flachen Zuführeinrichtungen ausgebildet, die sich in fächerartiger Anordnung senkrecht zur Führungsbahn erstrecken.

Der Erfindung liegt die Aufgabe zugrunde, eine kompakte Bestückvorrichtung von einfachem Aufbau anzugeben.

Diese Aufgabe wird erfindungsgemäß durch eine Vorrichtung gemäß Anspruch 1 gelöst.

Eine Vorrichtung zum Bestücken von zumindest einem Substrat mit elektrischen Bauelementen, die in einem Abholbereich der Vorrichtung bereitstellbar sind, weist zumindest einen Bestückkopf zum Aufnehmen und Handhaben zumindest eines der Bauelemente sowie einen linear in einer Längsrichtung verschiebbaren und positionierbaren Tisch auf, auf dem das flache Substrat in einer Arbeitsebene fixierbar ist. Der Bestückkopf ist in einer zur Arbeitsebene parallelen kreisrunden Führungsbahn eines stationären Trägers zwischen dem Abholbereich und dem Tisch verschiebbar und positionierbar, wobei Abholstellen der Bauelemente im Abholbereich entlang einer zur Führungsbahn parallelen Abholstrecke angeordnet sind. Der Bestückkopf ist mittels eines Linearmotors angetrieben, dessen Statorelemente am Träger verankert und dessen Spulenteil fest mit dem Bestückkopf gekoppelt ist, wobei die Statorelemente parallel zur Führungsbahn verlaufend aneinander gereiht sind. Die Vorrichtung ist dadurch gekennzeichnet, dass der Träger eine zum Substrat parallele ebene Oberfläche aufweist, auf der die Statorelemente in zirkulärer Reihung flach liegend angeordnet sind.

Die Abholstrecke und die Statorelemente können parallel zur Führungsbahn angeordnet sein. Das bedeutet z.B., dass sie auch konzentrisch zur Führungsbahn angeordnet sein können.

Der Linearmotor nach besteht z.B. aus den permanentmagnetischen, am Träger befestigten, zirkulär aneinander gereihten Statorelementen und einem verfahrbaren Spulenteil, das fest mit einem Gehäuse des Bestückkopfes gekoppelt ist, so dass die Bewegungen des Spulenteils spielfrei auf den Bestückkopf übertragen werden. Die permanentmagnetischen, z.B. flachen Statorelemente sind in einer zur Führungsebene parallelen Ebene flach liegend angeordnet. Die auf der Oberseite des Trägers angeordneten Statorelemente lassen sich z.B. mittels einer einfachen Schablone passgenau aufkleben. Die flache Anordnung der Statorelemente hat den Vorteil, dass auch die zugewandte Seite des Spulenteils eben ausgebildet werden kann und dass der Magnetspalt zwischen dem Spulenteil und den Statorelementen eine durchgehend gleiche Dicke bzw. Breite aufweisen kann. Dies ergibt definierte elektromagnetische Verhältnisse, die die Regelbarkeit des Linearmotors verbessern.

Der Bestückkopf kann ein Schlittenteil aufweisen, das in einem aerostatischen Lager geführt ist, wobei das aerostatische Lager Bestandteil der Führungsbahn ist, die Führungsbahn auf der Oberfläche des Trägers ausgebildet ist und wobei das auf der Oberfläche flach aufliegende Schlittenteil das Spulenteil des Linearmotors enthält.

Dementsprechend können Führungselemente des Bestückkopfes und die Führungsbahn des Trägers vorteilhaft als aerostatisches Lager ausgebildet sein, wobei sich das flächenhafte Lager im Wesentlichen in der Führungsebene erstreckt. Die in der Führungsebene orientierte Luftlagerung wirkt der elektromagnetischen Anzugskraft des Linearmotors entgegen. Die Führungsflächen weisen im Wesentlichen in eine Richtung, aus der sie gut bearbeitbar sind.

Die zur Führungsbahn komplementären Führungsflächen des Bestückkopfes sind an einem Schlittenteil ausgebildet, das auch das Spulenteil aufnimmt.

Der Bestückkopf kann am Schlittenteil lösbar verankert sein und lässt sich daher ohne die Eingriff in das Führungs- und Antriebssystem wechseln. Die radiale Führung wird durch eine am Träger ausgebildete Ringführung gebildet, bei der ein erhabener, im Querschnitt trapezförmiger, kreisrunder Führungssteg in eine entsprechende Führungsnut eines Schlittenteils eingreift.

Auf der der Abholstrecke gegenüberliegenden Seite des Tischs kann eine weitere Abholstrecke für weitere Bauelemente angeordnet sein, wobei die gegebenenfalls durchgehend ausgebildete Führungsbahn und die Reihe der Statorelemente entsprechend verlängert sein können. Durch die weitere Abholstrecke kann die Vielfalt an bereitgestellten Bauelementen verdoppelt werden.

Es kann ein weiterer Bestückkopf vorgesehen sein, der auf die weiteren Bauelemente zugreifen kann. Durch den weiteren Bestückkopf kann das Substrat durch die beiden Bestückköpfe abwechselnd bestückt werden, wobei der jeweils andere Bestückkopf Bauelemente abholt. Durch das annähernd kontinuierliche Bestücken kann die Bestückleistung der Vorrichtung entsprechend erhöht werden. Beide Bestückköpfe benötigen trotz ihrer unterschiedlich orientierten Führungsbereiche nur eine einzige durchgehende Führungs- und Messstruktur.

Auf der einer Bestückstrecke gegenüberliegenden Seite der Abholstrecke kann eine weiterer Tisch für ein weiteres Substrat vorgesehen sein, wobei die Führungsbahn und die Reihe der Statorelemente bis in den Bereich des Tischs verlängert sind und die beiden Tische in einer durchgehenden linearen Transportstrecke für die Substrate liegen. Dabei kann die Führungsbahn einen Vollkreis bildet und durch eine geschlossene Ringführung des Trägers gebildet sein.

Die weitere Bestückstrecke ermöglicht es, zwei Substrate gleichzeitig zu bestücken und die Bestückleistung der Vorrichtung weiter zu erhöhen, wobei sinnvoll vier Bestückköpfe kreuzweise abwechselnd bestücken und abholen können. Alle Bahnabschnitte können eine durchgehende gemeinsame Führungs-, Antriebs- und Messstruktur aufweisen, die von allen Bestückköpfen gemeinsam und überlappend genutzt wird, was den Herstellaufwand entsprechend verringert. Im Normalfall wird ein Bestückkopf die Bauelemente aus einem der Abholbereiche entnehmen und über einem der Tische auf das jeweilige Substrat aufsetzen. Bei einer Störung in einem der Bestückköpfe ist es möglich, das dieser in eine Warteposition ausweicht und die benötigten Bauelemente von einem der benachbarten Bestückköpfe abgeholt und bestückt werden. Bei geringer Leistungsanforderung ist es möglich, die Vorrichtung mit weniger Bestückköpfen zu betreiben oder auch alle Bauelemente auf einem Tisch zu bestücken.

Es ist möglich, in der durchgehenden Transportstrecke zwischen den beiden Tischen einen Pufferabschnitt für zumindest eines der Substrate vorzusehen, um die beiden Tische voneinander zu entkoppeln und die Wartezeiten beim Substratwechsel zu verringern. Insbesondere kann bei einer Verzögerung an einem der Tische am anderen Tisch ohne Unterbrechung weitergearbeitet werden. Ferner ist es auch möglich, den Pufferabschnitt in der Längsrichtung verschiebbar auszubilden und z.B. bei kurzen Substraten dem jeweiligen Tisch anzunähern, um die Übergabedauer zu verkürzen.

Der Bestückkopf kann zumindest einen Halter zum Aufnehmen und Absetzen eines der Bauelemente aufweisen, wobei der Halter am Bestückkopf senkrecht zur Führungsbahn und parallel zur Führungsebene verschiebbar gelagert ist.

Durch seine transversale radiale Auslenkbarkeit kann der Halter auch auf Bauelemente zugreifen, die nicht genau auf einer zur Führungsbahn parallelen Abhollinie angeordnet sind. Mehrere Halter eines Bestückkopfs können z.B. in einem gemeinsamen Gehäuse gelagert sein, das an einem Trägerteil des Bestückkopfes verschiebbar gelagert ist. Beim Bestücken ist es entsprechend möglich, auf dem Substrat eine von der Kreisbahn abweichende Position zu erreichen, ohne das Substrat selbst zu verschieben. Die transversale Auslenkbarkeit kann aber auch dadurch erreicht werden, dass der Halter exzentrisch in einem Rotor gelagert ist, der um eine senkrechte Mittelachse drehbar ist.

Die Abholstellen können an flachen, zueinander parallelen Zuführmodulen ausgebildet sein, die sich in der Querrichtung erstrecken und in bogenförmiger Reihung angeordnet sind, wobei die Zuführmodule in Aufnahmen zumindest eines Zuführtisches verschiebbar und fixierbar sind.

Die z.B. typgleichen flachen Zuführmodule können wechselbar in Aufnahmen eines Zuführtisches fixiert werden. Durch ihre zueinander parallele Ausrichtung ergibt sich eine kompakte Anordnung bei gleicher Bedienrichtung. Die Wechselbarkeit ist in aller Regel durch zueinander parallele Schiebeführungen des Zuführtisches gegeben. Die Aufnahmen sind daran so angeordnet, dass die Abholbereiche der Zuführmodule in der kreisbogenförmigen Abhollinie liegen. Konstruktionsbedingt variieren jedoch bei unterschiedlich großen Bauelementen deren Mittellagen, die somit nicht genau auf der Abhollinie liegen können. Die Mittelpunkte der Bauelemente sind die realen Abholstellen, auf die jeweils der verschiebbare Halter ausgerichtet werden kann. Falls der Halter am Bestückkopf hinreichend weit auslenkbar ist, kann die Abhollinie der Bauelemente in Abweichung von der Führungsbahn des Bestückkopfes auch flacher verlaufend ausgebildet und die Baubreite der Vorrichtung entsprechend verringert werden. Bei geringer Bauelementevielfalt und geringer Leistungsanforderung ist es möglich, die Vorrichtung mit nur einem der Zuführtische zu versehen.

Anstelle von Zuführmodulen kann auch ein mit Bauelementen belegtes Flächenmagazin angeordnet sein, dass einem Flächenmagazinwechsler entnommen und auf einem Schieber fixiert wird, der schrittweise in den Bereich der Abholstrecke verschiebbar ist.

Der Bestückkopf kann über in das Zentrum des Kreisbogens führende Leitungen mit stationären Einrichtungen der Vorrichtung verbunden sein. Durch die gebündelten Leitungen kann der Bestückkopf mit Druckluft bzw. Vakuum und elektrischer Energie versorgt werden. Datenleitungen des Leitungsbündels ermöglichen den erforderlichen Datenaustausch mit stationären Steuereinrichtungen. Die Leitungen sind in sich derart beweglich, dass die Bestückköpfe jeweils innerhalb z.B. eines Halbkreises verschiebbar sind. In der Regel werden sie zwischen einem der Abholbereiche und einem der Tische hin und her pendeln. Der Träger kann aber auch zur Führungsbahn parallel verlaufende elektrische Leiter aufweisen, über die der Bestückkopf mittels schleifender Stromabnehmer mit Energie versorgt wird. Der Bestückkopf kann außerdem über drahtlose Datenleitungen mit den Steuereinrichtungen verbunden sein. Durch diese Maßnahmen können die beweglichen Leitungen auf die Druckluft- und Vakuumversorgung reduziert werden.

Es ist ferner möglich, die zu den Bestückköpfen führenden Leitungen über eine Verteileinrichtung im Zentrum des Trägers zu führen und schleifend zu verbinden. Die Bestückköpfe können dann einer Richtung umlaufend betrieben werden, wodurch sich innerhalb eines Abhol-Bestückzyklus die Verfahrwege verringern

Entlang der in einem Vollkreis ausgebildeten Führungsbahn können jeweils diametral gegenüberliegend zwei der Tische und zwei der Abholstrecken angeordnet sein, wobei in der Führungsbahn vier der Bestückköpfe geführt sind und die Bestückköpfe jeweils zwischen einer der Abholstrecken und einem der benachbarten Tische verfahrbar sind.

Durch diese Weiterbildung wird die Vorrichtung besonders effektiv betrieben. Dabei werden alle Bestückköpfe annähernd gleichzeitig links- oder rechtdrehend in der Art einer Pendelbewegung verschoben. Für jeden der Bestückköpfe ist jeweils eine Kamera vorgesehen, was eine einfache Kalibrierung der Vorrichtung und eine sichere Lageerfassung der Bauelemente am Bestückkopf ermöglicht. Die Bestückköpfe legen hierbei jeweils nur eine Teilstrecke des Umfangs des Trägers zurück. Die Winkelauslenkung der Kabel zu den Bestückköpfen ist so gering, dass auf die aufwändige schleifende Verbindung verzichtet werden kann. Beim Ausfall eines der Bestückköpfe kann dieser in eine nicht störende Parkposition verfahren und die anderen Bestückköpfe können seine Aufgaben übernehmen, so dass die Substrate vollständig bestückt werden können.

Im Bereich einer Verbindungsstrecke kann eine stationäre Kamera zur Abbildung der abgeholten und am Bestückkopf gehaltenen Bauelemente angeordnet sein. Die Anordnung der Kamera im Bereich der Verfahrstrecke des Bestückkopfes ermöglicht eine schnelle Bildaufnahme der Bauelemente.

Die Adapterteile z.B. zum Ansaugen eines der Bauelemente an den Halter können zur Anpassung an unterschiedliche Bauelemente unterschiedliche Stirnflächen aufweisen. Dabei können auswechselbare Adapterteile für die Halter des Bestückkopfs in einem am Tisch gelagerten Magazin zusammengefasst sein. Durch die Anordnung der Adapterteile insbesondere an einer Längsseite des Tischs ist es möglich, die einzelnen Adapterteile in den Zugriffsbereich der Halter zu bringen und auszutauschen, ohne dass dafür eine zusätzliche Hilfsmechanik erforderlich ist.

Ausführungsbeispiele der Erfindung sind in der Zeichnung dargestellt und werden im Folgenden näher erläutert. Es zeigen:
- Figur 1: eine perspektivische Ansicht einer Vorrichtung zum Bestücken von Substraten mit elektrischen Bauelementen in einer maximalen Ausbaustufe,
- Figur 2: eine Draufsicht auf eine abgewandelte Vorrichtung nach Figur 1 in einer reduzierten Ausbaustufe, und
- Figur 3: eine weiter modifizierte Vorrichtung nach Figur 2 in einer minimalen Ausbaustufe.

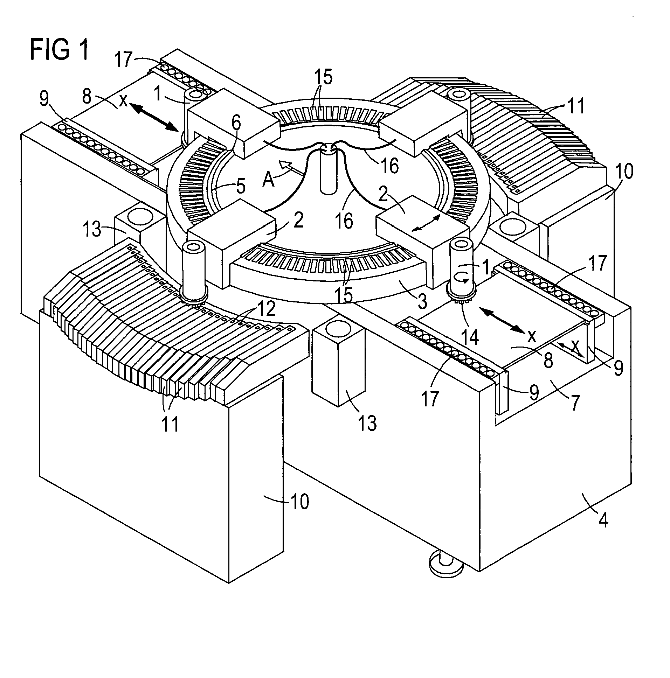

Nach Figur 1 weist eine Vorrichtung zum Bestücken von Substraten mit elektrischen Bauelementen vier Bestückköpfe 1 zum Handhaben der Bauelemente auf, die an jeweils einer Schlitteneinheit 2 z.B. wechselbar verankert sind. Damit ist es auch möglich, die Schlitteneinheiten 2 mit Bestückköpfen unterschiedlichen Typs zu versehen.

Ein scheibenförmiger runder Träger 3 ist auf einem Grundkörper 4 der Vorrichtung befestigt und auf seiner waagerechten flachen Oberseite mit einer kreisrunden Ringführung 5 versehen, die in entsprechend gebogene Führungsnuten 6 der aufliegenden Schlitteneinheiten 2 eingreift. Damit bildet die Ringführung 5 auch eine definierte Führungsbahn für die an den Schlitteneinheiten 2 fixierten Bestückköpfe 1. Eine senkrechte Mittelachse der Ringführung 5 liegt im Zentrum der Vorrichtung.

Die Schlitteneinheiten 2 sind auch an weiteren Führungsflächen des Trägers 3 z.B. mittels aerostatischer Lager geführt, die die Schlitteneinheiten 2 in einer waagerechten Führungsebene halten. Da alle Schlitteneinheiten 2 eine einzige Führungsstruktur des Stators 3 gemeinsam und überlappend nutzen, ist der Führungsaufwand entsprechend gering.

Unterhalb des Trägers 3 weist die Vorrichtung eine geradlinig durch die Mittelachse der Vorrichtung verlaufende Transportstrecke 7 für Substrate 8 auf, die gemäß dem Bewegungspfeil A in einer Längsrichtung x durch die Vorrichtung hindurchgeführt werden. Am Anfang der Transportstrecke 7 wird das Substrat 8 einem in der Längsrichtung x verschiebbaren Tisch 9 übergeben und darauf fixiert, wobei der genau positionierbare Tisch 9 einen Teil der Transportstrecke 7 bildet und überdeckt. Die Bewegungsbahn des Bestückkopfes 1 über dem Tisch 9 bildet eine Bestückstrecke.

Ein weiterer gleichartiger Tisch 9 ist am anderen Ende der Transportstrecke 7 angeordnet, von dem aus die Substrate 8 an eine externe Transporteinrichtung übergeben werden können. Die Tische 9 können soweit verschiebbar sein, dass die Substrate 8 unmittelbar übergeben werden können. Es ist aber auch möglich, die Substrate 8 über einen zentralen Pufferabschnitt zu führen, so dass die beiden Tische 9 unabhängig voneinander arbeiten können.

An den beiden Tischen 9 sind längsseitig schmale Magazine 17 mit aneinander gereihten Aufnahmen für auswechselbare Adapterteile für die Halter 14 angeordnet. Die Adapterteile z.B. zum Ansaugen eines der Bauelemente an den Halter 14 können zur Anpassung an unterschiedliche Bauelemente unterschiedliche Stirnflächen aufweisen. Durch die Anordnung der Adapterteile an einer Längsseite des Tischs ist es mit den Positioniermitteln des Tischs und des Bestückkopfes möglich, die einzelnen Adapterteile in den Zugriffsbereich der Halter zu bringen und auszutauschen, ohne dass dafür eine zusätzliche Hilfsmechanik erforderlich ist.

Zu beiden Seiten der Transportstrecke 7 sind Zuführtische 10 mit schmalen wechselbaren Zuführmodulen 11 für die in Gurten gespeicherten Bauelemente an den Grundkörper 4 angesetzt. Die senkrecht zur Längsrichtung x orientierten Zuführmodule 11 sind in Aufnahmen des Zuführtisches 10 verschiebbar gelagert und in dieser Richtung unmittelbar aneinander gereiht. Die Bauelemente werden an Abholstellen 12 der Zuführmodule 11 bereitgestellt, die an den der Transportstrecke 7 zugewandten inneren Enden der Zuführmodule 11 an deren Oberseite ausgebildet sind. Die Aufnahmen für die Zuführmodule 11 sind so ausgebildet, dass die Abholstellen 12 zumindest annähernd auf einem zur Ringführung 5 konzentrischen Bogen liegen und eine entsprechende Abholstrecke bilden. Die Oberflächen der Substrate 8 und die Abholstellen 12 der Bauelemente liegen annähernd in einer zur Führungsebene parallelen Arbeitsebene der Vorrichtung.

In den Bereichen zwischen den Abholstellen 12 und den Tischen 9 sind unterhalb der Bewegungsbahn der Bestückköpfe 1 nach oben gerichtete Kameras 13 angeordnet, die die Bauelemente an den Bestückköpfen 1 zwecks Lagekorrektur beim Bestücken erfassen können. Auf der Oberseite des Trägers 3 sind in fächerartiger zirkulärer Reihung als Statorelemente 15 dienende Magnetteile im Vollkreis angeordnet, die mit nicht dargestellten Spulenteilen der Schlitteneinheiten 2 in der Art eines Linearmotors zusammenwirken. Damit sind die Schlittenteile 2 in der Umfangsrichtung voneinander unabhängig verschiebbar, wobei ein nicht dargestellter Ringmaßstab am Träger 3 eine genaue Winkelpositionierung ermöglicht.

Die Bestückköpfe 1 sind in nicht näher dargestellter Weise mit mehreren Haltern 14 zum Aufnehmen und Absetzen der Bauelemente versehen. Die Halter 14 sind in senkrechter Richtung verschiebbar in einem Rotor gelagert, der um eine senkrechte Mittelachse drehbar ist, um die die Halter 14 konzentrisch verteilt angeordnet sind. Dadurch können die Halter 14 an den Bestückköpfen 1 radial zu deren kreisbogenförmigen Bewegungsbahn parallel zur Führungsebene ausgelenkt werden und so eine streifenförmige Strecke überdecken, so dass auch radial von der Bewegungsbahn abweichende Bauelemente erfasst werden können. Beim Bestücken der mittels der Kamera 13 vermessenen Bauelemente können diese durch eine entsprechende Rotordrehung in die erforderliche Bestücklage gedreht werden. Von den einzelnen Bestückköpfen 1 sind bewegliche elektrische und pneumatische Leitungen 16 in das Zentrum des Trägers 3 geführt und mit stationären Funktionseinheiten der Vorrichtung verbunden.

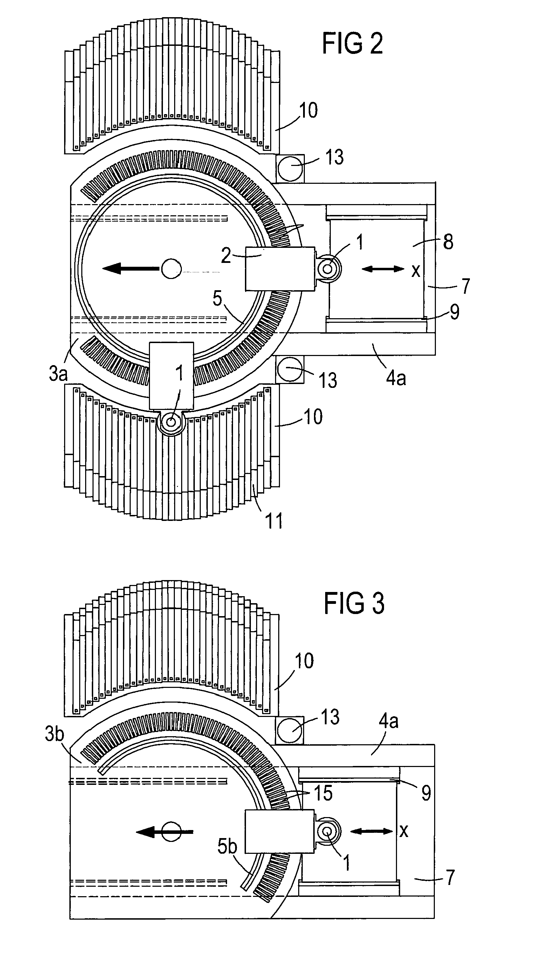

Figur 2 zeigt eine Draufsicht auf eine abgewandelte Vorrichtung nach Figur 1 mit weitgehend identischen Funktionsmaßen und Bauteilen, wobei einer der Tische 9 entfernt ist und ein abgewandelter Grundkörper 4a der Vorrichtung entsprechend verkürzt ist. In dem zugeordneten Winkelbereich der Bewegungsbahn der Bestückköpfe 1 ist auch ein abgewandelter Träger 3a quer zur Längsrichtung x beschnitten und verkürzt. Die Reihe der Statorelemente 15 ist entsprechend unterbrochen. Zwei der Kameras 13 sind in der Verbindungsstrecke zwischen den Zuführtischen 10 und dem Tisch 9 verblieben. Es sind nur noch zwei der Bestückköpfe 1 vorgesehen. Die Vorrichtung hat eine geringere Erstreckung in der Längsrichtung x und kann mit geringerem Aufwand hergestellt werden.

Bei einer weiter modifizierten Vorrichtung nach Figur 3 ist nur noch einer der Zuführtische 10 am Grundkörper 4a angedockt. Ein modifizierter Träger 3b ist auf der freibleibenden Längsseite des Grundkörpers 4a in der Längsrichtung beschnitten. Durch diese Maßnahmen verringert sich die Gesamtbreite der Vorrichtung erheblich. Es ist nur noch einer der Bestückköpfe 1 sowie eine der Kameras 13 vorgesehen. Eine modifizierte Ringführung 5b sowie die Reihe der Statorelemente 15 sind auf den Arbeitsbereich des Bestückkopfes 1 verkürzt.

### Bezugszeichen

| | |
|---|---|
| 1 | Bestückkopf |
| 2 | Schlitteneinheit |
| 3, 3a, 3b | Träger |
| 4, 4a | Grundkörper |
| 5, 5b | Ringführung |
| 6 | Führungsnut |
| 7 | Transportstrecke |
| 8 | Substrat |
| 9 | Tisch |
| 10 | Zuführtisch |
| 11 | Zuführmodul |
| 12 | Abholstelle |
| 13 | Kamera |
| 14 | Halter |
| 15 | Statorelement |
| 16 | Leitung |
| 17 | Magazin |

## Patentansprüche

1. Vorrichtung zum Bestücken von zumindest einem Substrat (8) mit elektrischen Bauelementen, die in einem Abholbereich der Vorrichtung bereitstellbar sind,
mit zumindest einem Bestückkopf (1) zum Aufnehmen und Handhaben zumindest eines der Bauelemente sowie
mit einem linear in einer Längsrichtung (x) verschiebbaren und positionierbaren Tisch (9), auf dem das flache Substrat (8) in einer Arbeitsebene fixierbar ist,
wobei der Bestückkopf (1) in einer zur Arbeitsebene parallelen kreisrunden Führungsbahn eines stationären Trägers (3) zwischen dem Abholbereich und dem Tisch verschiebbar und positionierbar ist,
wobei Abholstellen (12) der Bauelemente im Abholbereich entlang einer zur Führungsbahn parallelen Abholstrecke angeordnet sind,
wobei der Bestückkopf mittels eines Linearmotors angetrieben ist, dessen Statorelemente am Träger (3, 3a, 3b) verankert und dessen Spulenteil fest mit dem Bestückkopf (1) gekoppelt ist,
wobei die Statorelemente (15) parallel zur Führungsbahn verlaufend aneinander gereiht sind,
**dadurch gekennzeichnet,**
**dass** der Träger (3, 3a, 3b) eine zum Substrat parallele ebene Oberfläche aufweist, auf der die Statorelemente (15) in zirkulärer Reihung flach liegend angeordnet sind

2. Vorrichtung nach Anspruch 1, **dadurch gekennzeichnet,**
**dass** der Bestückkopf (1) ein Schlittenteil (2) aufweist, das in einem aerostatischen Lager geführt ist,
**dass** das aerostatische Lager Bestandteil der Führungsbahn ist, wobei die Führungsbahn auf der Oberfläche des Trägers (3) ausgebildet ist und
**dass** das auf der Oberfläche flach aufliegende Schlittenteil das Spulenteil des Linearmotors enthält.

3. Vorrichtung nach Anspruch 1 oder 2, **dadurch gekennzeichnet,**
**dass** auf der der Abholstrecke gegenüberliegenden Seite des Tischs (9) eine weitere Abholstrecke für weitere Bauelemente angeordnet ist und
**dass** die Führungsbahn durchgehend ausgebildet ist, wobei die Führungsbahn und die Reihe der Statorelemente (15) entsprechend verlängert sind.

4. Vorrichtung nach Anspruch 3, **dadurch gekennzeichnet,**
**dass** ein weiterer Bestückkopf (1) vorgesehen ist, der auf die weiteren Bauelemente zugreifen kann.

5. Vorrichtung nach einem der Ansprüche 1 bis 4, **dadurch gekennzeichnet,**
**dass** auf der einer Bestückstrecke gegenüberliegenden Seite der Abholstrecke ein weiterer Tisch (9) für ein weiteres Substrat (8) vorgesehen ist,
**dass** die Führungsbahn und die Reihe der Statorelemente bis in den Bereich des Tischs verlängert sind und
**dass** die beiden Tische (9) in einer durchgehenden linearen Transportstrecke (7) für die Substrate (8) liegen.

6. Vorrichtung nach Anspruch 5, **dadurch gekennzeichnet,**
**dass** die Führungsbahn einen Vollkreis bildet und durch eine geschlossene Ringführung (5) des Trägers (3) gebildet ist.

7. Vorrichtung nach einem der vorhergehenden Ansprüchen, **dadurch gekennzeichnet, dass** der Bestückkopf (1) zumindest einen Halter (14) zum Aufnehmen und Absetzen eines der Bauelemente aufweist und
dass der Halter (14) am Bestückkopf senkrecht zur Führungsbahn und parallel zur Führungsebene verschiebbar gelagert ist.

8. Vorrichtung nach einem der vorhergehenden Ansprüche, **dadurch gekennzeichnet, dass** die Abholstellen (12) an flachen, zueinander parallelen Zuführmodulen (11) ausgebildet sind, die sich in der Querrichtung erstrecken und in bogenförmiger Reihung angeordnet sind und
dass die Zuführmodule (11) in Aufnahmen zumindest eines Zuführtisches (10) verschiebbar und fixierbar sind.

9. Vorrichtung nach einem der vorhergehenden Ansprüche, **dadurch gekennzeichnet, dass** der Bestückkopf (1) über in das Zentrum des Kreisbogens führende Leitungen (16) mit stationären Einrichtungen der Vorrichtung verbunden ist.

10. Vorrichtung nach einem der vorhergehenden Ansprüche, **dadurch gekennzeichnet, dass** entlang der in einem Vollkreis ausgebildeten Führungsbahn jeweils diametral gegenüberliegend zwei der Tische (9) und zwei der Abholstrecken angeordnet sind und dass in der Führungsbahn vier der Bestückköpfe (1) geführt sind, **dadurch gekennzeichnet,**
**dass** die Bestückköpfe (1) jeweils zwischen einer der Abholstrecken und einem der benachbarten Tische (9) verfahrbar sind.

11. Vorrichtung nach einem der vorhergehenden Ansprüche, **dadurch gekennzeichnet, dass** im Bereich einer Verbindungsstrecke eine stationäre Kamera (13) zur Abbildung der abgeholten und am Bestückkopf (1) gehaltenen Bauelemente angeordnet ist.

12. Vorrichtung nach einem der vorhergehenden Ansprüche, **dadurch gekennzeichnet, dass** auswechselbare Adapterteile für die Halter (14) des Bestückkopfs (1) in einem am Tisch (9) gelagerten Magazin zusammengefasst sind.
